# EUROPÄISCHE PATENTANMELDUNG

(11) **EP 1 207 399 A2**
(43) Veröffentlichungstag der Anmeldung: **22.05.2002**
(21) Anmeldenummer: 01000627.8
(22) Anmeldetag: 14.11.2001
(51) Int. Cl.: G01R 31/3185, G06F 1/00

(54) **Verfahren zum Schutz einer Schaltungsanordnung zum Verarbeiten von Daten**

(30) Priorität: 15.11.2000 DE 10056591
(71) Anmelder: Philips Corporate Intellectual Property GmbH, 52064 Aachen (DE); Koninklijke Philips Electronics N.V., 5621 BA Eindhoven (NL)
(72) Erfinder: Müller, Detlef, c/o Philips Corp. Int. Prop. GmbH, 52064, Aachen (DE)
(74) Vertreter: Volmer, Georg, Dipl.-Ing.

(57) **Zusammenfassung**

Beschrieben wird ein Verfahren zum Schutz einer Schaltungsanordnung zum Verarbeiten von Daten, insbesondere eines Mikroprozessors, vorzugsweise eines sogenannten Smart-Card-Controllers, in welcher Schaltungsanordnung während und/oder zum Abschluß der Fertigung dieser Schaltungsanordnung zum Durchführen von "Scantests" zur Fertigungskontrolle
- durch Zusammenschalten von Speicherzellen der Schaltungsanordnung, vorzugsweise aus als Flip-Flops ausgebildeter Speicherzellen, in vorbestimmter Konfiguration aus diesen Speicherzellen eine Schieberegisterkette gebildet wird,
- mittels dieser Schieberegisterkette und/oder einer sonstigen, in der Schaltungsanordnung gebildeten Schieberegisterkette beliebige Zustände in den Speicherzellen der Schaltungsanordnung erzeugt und in vorbestimmter Weise zur Prüfung der Funktionsfähigkeit der damit geladenen Speicherzellen der Schaltungsanordnung ausgewertet werden,
- nach Beendigung des bzw. der "Scantests" zur Fertigungskontrolle die Schieberegisterkette unbrauchbar gemacht wird.

Durch diese Unbrauchbarmachung einer Schieberegisterkette in Schaltungsanordnungen zum Verarbeiten von Daten, insbesondere vonMikroprozessoren, vorzugsweise sogenannter Smart-Card-Controller nach dem Testen, d.h. nach der Ausführung des bzw. der Produktionstests (d.h. der Fertigungskontrolle), wird es unmöglich, undefinierte Zustände über die Schieberegisterkette in die Schaltungsanordnung zu laden und auf diese Weise Angriffe auf Sicherheitsfunktionen der Schaltungsanordnung zu versuchen.

## Beschreibung

Die Erfindung bezieht sich auf ein Verfahren zum Schutz einer Schaltungsanordnung zum Verarbeiten von Daten.

In Schaltungsanordnungen zum Verarbeiten von Daten, insbesondere in Mikroprozessoren, beispielsweise solchen, die in Chipkateneingesetzt werden - sogenannten Smart-Card-Controllern - werden zur höheren Fehlerabdeckung neben Selbsttests aus einem vorzugsweise im Mikroprozessor integrierten Nur-Lese-Speicher, auch als Test-ROM bezeichnet, zunehmend sogenannte "Scantests" während der Fertigungskontrolle- den sogenannten Produktionstests - durchgeführt. Hierbei können nach an sich bekannten Verfahren mittels einer Schieberegisterkette beliebige Zustände in den als Flip-Flops ausgebildeten Speicherzellen der Schaltungsanordnung zum Verarbeiten von Daten, also insbesondere eines Mikroprozessors oder vorzugsweise eines Smart-Card-Controllers, hergestellt werden. Das bedeutet, daß nach einer Aktivierung der "Scantest"-Betriebsart die Schieberegisterkette komplett vorhanden ist und das Laden beliebiger Zustände in die an der Schieberegisterkette beteiligten Flipflops erlaubt.

Diese Zustände werden gezielt zur Prüfung der Funktionsfähigkeit der damit geladenen Speicherzellen der Schaltungsanordnung ausgewertet.

Es zeigt sich jedoch, daß dieser Betriebszustand auch nach der Fertigung im bestimmungsgemäßen Betrieb der Schaltungsanordnung wiederherstellbar und dies unter Sicherheitsaspekten nicht akzeptabel ist, da auf diese Weise Angriffe auf Sicherheitsfunktionen der Schaltungsanordnung möglich wären.

Die Erfindung hat die Aufgabe, ein Verfahren zu schaffen, durch welches derartige Angriffe auf Sicherheitsfunktionen der Schaltungsanordnung unmöglich gemacht werden.

Erfindungsgemäß wird diese Aufgabe gelöst durch ein Verfahren zum Schutz einer Schaltungsanordnung zum Verarbeiten von Daten, insbesondere eines Mikroprozessors, vorzugsweise eines sogenannten Smart-Card-Controllers, in welcher Schaltungsanordnung während und/oder zum Abschluß der Fertigung dieser Schaltungsanordnung zum Durchführen von "Scantests" zur Fertigungskontrolle
- durch Zusammenschalten von Speicherzellen der Schaltungsanordnung vorzugsweise aus als Flip-Flops ausgebildeter Speicherzellen, in vorbestimmter Konfiguration aus diesen Speicherzellen eine Schieberegisterkette gebildet wird,
- mittels dieser Schieberegisterkette und/oder einer sonstigen, in der Schaltungsanordnung gebildeten Schieberegisterkette beliebige Zustände in den Speicherzellen der Schaltungsanordnung erzeugt und in vorbestimmter Weise zur Prüfung der Funktionsfähigkeit der damit geladenen Speicherzellen der Schaltungsanordnung ausgewertet werden,
- nach Beendigung des bzw. der "Scantests" zur Fertigungskontrolle die Schieberegisterkette unbrauchbar gemacht wird.

Durch diese Unbrauchbarmachung einer Schieberegisterkette in Schaltungsanordnungen zum Verarbeiten von Daten, insbesondere von Mikroprozessoren, vorzugsweise sogenannter Smart-Card-Controller nach dem Testen, d.h. nach der Ausführung des bzw. der Produktionstests (d.h. der Fertigungskontrolle), wird es unmöglich, undefinierte Zustände über die Schieberegisterkette in die Schaltungsanordnung zu laden und auf diese Weise Angriffe auf Sicherheitsfunktionen der Schaltungsanordnung zu versuchen. Dieser Vorteil wird durch eine geringfügige Erhöhung des Schaltungsaufwandes erkauft, da zum Durchführen des erfindungsgemäßen Verfahrens zusätzliche Logikbauelemente, insbesondere sogenannte "Fuses" und Gatter, erforderlich werden.

In einer Ausgestaltung des erfindungsgemäßen Verfahrens wird das Durchrühren von "Scantests" durch einen mit Hilfe einer programmierbaren Schalteinrichtung (einer sogenannten "Fuse") ein- und ausschaltbaren Testmodedecoder gesteuert und ist es im Testmodedecoder nur bei deaktivierter programmierbarer Schalteinrichtung ("Fuse") möglich, den "Scantest" auszuwählen, wodurch die Schieberegisterkette vermittels eines Aktivierens der programmierbaren Schalteinrichtung ("Fuse") unbrauchbar gemacht wird.

In einer weiteren Ausgestaltung des erfindungsgemäßen Verfahrens wird die Schieberegisterkette nach Beendigung des bzw. der "Scantests" zur Fertigungskontrolle mittels vorzugsweise als sogenannte "EEPROM fuses" ausgebildeter, programmierbarer Schalteinrichtungen an einer Mehrzahl von Stellen unterbrochen.

Als zusätzliche Schutzmaßnahme wird so die Schieberegisterkette mittels der "EEPROM fuses" an vielen Stellen unterbrochen, so daß selbst unter Umgehung des Testmodedecoders die Schieberegisterkette nicht mehr benutzbar ist. Damit ist es unmöglich, undefinierte Zustände über die Schieberegisterkette in die Schaltungsanordnung, beispielsweise einen Smart-Card-Controller, zu laden.

## Patentansprüche

1. Verfahren zum Schutz einer Schaltungsanordnung zum Verarbeiten von Daten, insbesondere eines Mikroprozessors, vorzugsweise eines sogenannten Smart-Card-Controllers, in welcher Schaltungsanordnung -während und/oder zum Abschluß der Fertigung dieser Schaltungsanordnung zum Durchführen von "Scantests" zur Fertigungskontrolle
• durch Zusammenschalten von Speicherzellen der Schaltungsanordnung, vorzugsweise aus als Flip-Flops ausgebildeter Speicherzellen, in vorbestimmter Konfiguration aus diesen Speicherzellen eine Schieberegisterkette gebildet wird,
• mittels dieser Schieberegisterkette und/oder einer sonstigen, in der Schaltungsanordnung gebildeten Schieberegisterkette beliebige Zustände in den Speicherzellen der Schaltungsanordnung erzeugt und in vorbestimmter Weise zur Prüfung der Funktionsfähigkeit der damit geladenen Speicherzellen der Schaltungsanordnung ausgewertet werden,
• nach Beendigung des bzw. der "Scantests" zur Fertigungskontrolle die Schieberegisterkette unbrauchbar gemacht wird.

2. Verfahren nach Anspruch 1,
**dadurch gekennzeichnet, daß** das Durchführen von "Scantests" durch einen mit Hilfe einer programmierbaren Schalteinrichtung (einer sogenannten "Fuse") ein- und ausschaltbaren Testmodedecoder gesteuert wird und daß es im Testmodedecoder nur bei deaktivierter programmierbarer Schalteinrichtung ("Fuse") möglich ist, den "Scantest" auszuwaehlen, wodurch die Schieberegisterkette vermittels eines Aktivierens der programmierbaren Schalteinrichtung ("Fuse") unbrauchbar gemacht wird.

3. Verfahren nach Anspruch 1 oder 2,
**dadurch gekennzeichnet, daß** die Schieberegisterkette nach Beendigung des bzw. der "Scantests" zur Fertigungskontrolle mittels vorzugsweise als sogenannte "EEPROM fuses" ausgebildeter, programmierbarer Schalteinrichtungen an einer Mehrzahl von Stellen unterbrochen wird.
